# EUROPEAN PATENT APPLICATION

(11) **EP 4 292 738 A1**
(43) Date of publication of application: **20.12.2023**
(21) Application number: 23179595.6
(22) Date of filing: 15.06.2023
(51) Int. Cl.: B23C 3/13, B23Q 11/10, B26F 1/38, B32B 38/10, H05K 3/04

(54) **METHOD AND DEVICE FOR PRODUCING A PRODUCT COMPRISING A SUBSTRATE WITH AT LEAST ONE PATTERNED LAYER USING A CUTTING FLUID**

(30) Priority: 15.06.2022 SE 2250719
(71) Applicant: DP Patterning AB, 602 33 Norrköping (SE)
(72) Inventor: Nordlinder, Staffan, 603 85 Norrköping (SE); Öd Österman, David, 603 37 Norrköping (SE)
(74) Representative: AWA Sweden AB

(57) **Abstract**

The document relates to a method of producing a product comprising a substrate with at least one patterned layer from a multilayer material (1), the method comprising: providing the multilayer material (1) comprising at least a first layer (10) and a second layer (20); providing a cutting fluid (8) on an exposed surface of the multilayer material (1); and passing the multilayer material (1) through at least one nip (6), wherein said nip (6) is provided by a milling cutter (51) cooperating with a patterned cliché cylinder (52), to at least partially, as seen in a thickness direction of the first layer (10), remove at least some predetermined portions of material from at least the first layer (10) of the multilayer material (1). The cutting fluid (8) is provided on the exposed surface (15) by roll-to-roll processing the cutting fluid (8) on the exposed surface (15).

## Description

### Technical field

The present document relates to a method and a device for producing a product comprising a substrate with at least one patterned layer.

### Background

A known method of manufacturing electrical conductors and components on flexible backings or carriers is to firstly apply a thin layer (<1 mm) of conducting material, e.g. a metal or metal alloy or doped resin material, on the flexible backings or carriers, and secondly remove not wanted parts of said layer from the flexible backings or carriers by etching with chemical substances.

However, such method has several drawbacks. In particular, the process has to be done in a number of separate steps. Thus, it is only possible to perform this technique in a continuous process if the feeding rate of the material is low. Furthermore, the employed chemical substances used in this type of method is disadvantageous in terms of waste management problems and negative environmental impact.

In EP1665912B1, there is disclosed a device and a method, wherein a cliché presses out the desired pattern on a material, e.g. in form of a continuous web or a sheet, consisting of a conducting top layer and a dielectric bottom carrier. A milling wheel mechanically removes the protruding pattern from the top layer (also referred to as the pattern layer), while the bottom carrier remains untouched. This leaves a conductive pattern on the material. The removal of material from the conducting top layer is performed simultaneously with the step of pressing out the desired pattern on the material.

Thus, EP1665912B1 discloses a method and device that facilitates the manufacturing of electrical components in a fast and reliable way, using a single step, and which does not require etching with chemical substances. The device and method can be used to produce for example heaters, flexible circuit boards etc. Such device and method have been proven in particular efficient for providing conductive patterns on materials with a conductive layer having a thickness of up to about 40 µm, e.g. a material comprising an aluminum (Al) layer having a thickness of up to about 40 µm.

In order to achieve a well-defined pattern and a product with high quality, it is also known to apply a layer of lubricant before the milling. The lubricant is applied over the whole top layer of said material by means of an aerosol. Although the application of lubricant enhances the quality of the end product, the application of lubricant also entails certain drawbacks, such as increased costs due to large amount of lubricant required and the need of an additional process step for cleaning the material after the milling. The cleaning is required to remove any remaining lubricant but is costly and difficult. In addition, applying the lubricant by means of an aerosol entails certain drawbacks since it contaminates both the working environment and the production equipment. It is also problematic regulating the amount of lubricant applied since it can be affected by external parameters such as the ambient air pressure, the ambient temperature and/or humidity.

Thus, it is desirable to provide a method and device that allows for manufacturing of a structure/pattern on a multilayer material, wherein the produced product has high quality and wherein the manufacturing is cost-efficient, resource-efficient and/or which has a reduced negative impact on the working environment.

### Summary

It is an object of the present disclosure, to provide an improved method and device for producing a product comprising a substrate with at least one patterned layer, which eliminates or alleviates at least some of the drawbacks of the prior art.

More specific objects include providing an improved method and device that is environmentally friendly and cost-efficient, and which can provide high-quality patterns on a multilayer material.

The invention is defined by the appended independent claims. Embodiments are set forth in the appended dependent claims and in the following description and drawings.

According to a first aspect, there is provided a method of producing a product comprising a substrate with at least one patterned layer from a multilayer material, the method comprising: providing the multilayer material comprising at least a first layer and a second layer, providing a cutting fluid on an exposed surface of the multilayer material, and passing the multilayer material through at least one nip, wherein said nip is provided by a milling cutter cooperating with a patterned cliché cylinder, to at least partially, as seen in a thickness direction of the first layer, remove at least some predetermined portions of material from at least the first layer of the multilayer material. Said cutting fluid being provided on the exposed surface by roll-to-roll processing the cutting fluid on the exposed surface.

The multilayer material comprises at least two layers of material. The multilayer material is a flexible material. The multilayer material may be provided in form of a web, such as a foil, film etc. The multilayer material may be provided in form of a continious web or in form of a sheet.

The second layer can be seen to form a substrate layer or a bottom carrier layer. The second layer may be dielectric. Thus, the second layer can be seen to form said substrate.

The first layer can be seen to form a layer that is to be provided with a structure or pattern. The first layer may be conductive. The first layer may be seen to form a top layer. Alternatively, in the case the multilayer material comprises more than two layers, the first layer may be seen to form an intermediate layer. For example, the first layer may be seen to form an intermediate conductive layer sandwiched between two layers of dielectric material, for example between a dielectric substrate and a dielectric cover layer, or beteween a dielectric substrate and an intermediate dielectric layer.

At least one adhesive layer may be provided between the first and second layers. Thus, the multilayer material may be seen to comprise at least one adhesive layer.

A "cutting fluid" may be provided in form of a lubricant. The lubricant may be any suitable lubricant, such as for example an alcohol, a fatty alchol, oil, water, tensides or a blend of a plurality of these substances.

A "nip" can be seen to be defined by a cliché cylinder and a cooperating milling cutter. The cliché cylinder may be mounted in fixed bearings on a stand while the milling cutter may be movably arranged in a direction to or from the patterned cliché cylinder in order to widen or shorten said nip. Alternatively, the cliché cylinder may be movable relative the milling cutter. Alternatively, both the cliché cylinder and the milling cutter may be movable relative one another. In said nip, the multilayer material can be forced against an envelope surface of the cliché cylinder, by applying a tensile stress on the running multilayer material. Thereby, at least the first layer of the multilayer material can be shaped into a three-dimensional pattern of ridges and valleys.

The term "milling cutter" is meant to include all rotating bodies having an abrading, abrasive or milling envelope surface equipped with teeth, grit or abrasive grains of, for example, sand, diamond particles or similar.

The milling cutter can be provided in form a milling cylinder. The milling cutter may be provided in form of a cylindrical milling wheel, with cutting teeth running along an axial direction of an envelope surface of the cylinder, such as helically or straight along the axial direction.

The patterned cliché cylinder can be provided in the form of a cylindrical carrier with a patterned envelope surface. The pattern comprises raised and recessed portions, which make up the pattern, such that raised portions correspond to material portions that are to be cut away and recessed portions correspond to material portions that are to be kept.

The method can be used to produce a product comprising a substrate with at least one 1D-patterned, 2D-patterned, or 3D-patterned layer from a multilayer material.

The "predetermined portions of material" are the portions of the first layer that are to be removed through the entire thickness of the first layer, in order to form a pattern from the first layer. The pattern may for example be a 2D-pattern, such as a pattern that varies both in a machine direction and in a cross machine direction, i.e. a pattern that is constant in neither the machine direction nor the cross machine direction.

Thus, the multilayer material is passed through at least one nip to selectively remove at least some predetermined portions of material from at least the first layer of the multilayer material, in accordance with a pattern of the patterned cliché cylinder, whereby the patterned layer is formed from the first layer.

The removal of the predetermined portions of material from the first layer may be formed in one or in several subsequent milling steps. For each milling step, the multilayer material is passed through one nip. Thus, the multilayer material may be passed through one nip more than once. As another alternative, the multilayer material may be passed through several subsequent nips.

In the case that the removal are performed in several milling steps, the removal of the predetermined portions of material from the first layer is performed partially in one or several first milling steps and is completed in a subsequent milling step. After the final milling step, at least the first layer has been cut through and predetermined portions of material have been removed from the first layer, such that at least a portion of an adjacent, underlying layer of the multilayer material is exposed. Thus, a pattern can be seen to be formed in at least the first layer of the multilayer material.

The exposed surface onto which the cutting fluid is provided is formed of at least some material that is to be removed. Thus, a cutting fluid may be provided onto a surface of at least some predetermined portions of material that is to be removed. The cutting fluid may be provided such as to cover the whole surface of said at least some predetermined portions of material. Alternatively, the cutting fluid may be provided such as to partly cover the surface of said at least some predetermined portions of material that is to be removed.

Further, the exposed surface onto which the cutting fluid is provided may also be formed of at least some material that is not to be removed. Thus, in addition to providing a cutting fluid onto the surface of at least some predetermined portions of material that is to be removed, a cutting fluid may also be provided onto the surface of material that is not to be removed.

According to one group of embodiments, the exposed surface onto which the cutting fluid is provided is formed only of material that is to be removed.

According to another group of embodiments, the exposed surface onto which the cutting fluid is provided has an area substantially corresponding to a surface area of a top layer of the multilayer material, as seen when in use. Thus, a cutting fluid may be provided substantially over the entire surface of the top layer of the multialyer material, as seen when in use.

Providing said cutting fluid on the exposed surface by roll-to-roll processing may comprise providing said cutting fluid on the exposed surface by for example inkjet printing, Drop-on-Demand (DOD)-printing, flexographic printing (flexography), offset printing, gravure printing, screen printing, slot die coating and/or blade coating.

According to a method as described above, a high quality product with a well-defined pattern can be produced. Furthermore, an improved control of the application of cutting fluid can be achieved and the amount of cutting fluid can be reduced. Hence a more resource-efficient process can be provided. Furthermore, the working environment can be improved as a result of a reduction of contaniments of the cutting fluid. Maintenance of the production equipment is also enabled as a result of the reduction of contaniments. Furthermore, the need for cleaning the multilayer material after milling is eliminated or significantly reduced by the above method.

The roll-to-roll processing may comprise printing the cutting fluid on the exposed surface.

Alternatively, or additionally, the roll-to-roll processing may comprise coating the cutting fluid on the exposed surface.

The roll-to-roll processing may comprise inkjet printing, Drop-on-Demand-printing, flexographic printing, offset printing, gravure printing, screen printing, slot die coating and/or blade coating the cutting fluid on the exposed surface.

The method may comprise selectively providing said cutting fluid on the exposed surface in accordance with a pattern, which correlates to at least some of said predetermined portions of material that are to be removed from at least the first layer.

Said cutting fluid may be selectively provided on the exposed surface in accordance with a 1D-pattern.

Said cutting fluid may be selectively provided on the exposed surface in accordance with a 2D-pattern.

Hence, according to the method, a cutting fluid may be provided onto the multilayer material in form of a pattern. The pattern is correlated to predetermined portions of material that are to be removed from at least the first layer of the multilayer material. The pattern may substantially match the pattern of said cliché cylinder. Alternatively, the pattern may differ from the pattern of said cliché cylinder. For example, the pattern may be slightly modified, such as relatively enlarged, reduced or displaced as compared with the pattern of said cliché cylinder.

A 1D-pattern may be designed such that there is at least one line extending in the machine direction, along which there is at least one portion exhibiting the cutting fluid and at least one portion devoid of the cutting fluid; or there is at least one line extending in the cross machine direction, along which there is at least one portion exhibiting the cutting fluid and at least one portion devoid of the cutting fluid.

A 2D pattern may be designed such that there is at least one line extending in the machine direction, along which there is at least one portion exhibiting the cutting fluid and at least one portion devoid of the cutting fluid; and there is at least one line extending in the cross machine direction, along which there is at least one portion exhibiting the cutting fluid and at least one portion devoid of the cutting fluid.

Selectively providing said cutting fluid on the exposed surface may comprise selectivley providing said cutting fluid on the exposed surface by for example inkjet printing, Drop-on-Demand (DOD)-printing, flexographic printing (flexography), offset printing, gravure printing, screen printing, slot die coating and/or blade coating.

Hence a more resource-efficient process can be provided.

As an alternative, the method may comprise providing said cutting fluid such as to cover a top layer of the multilayer material.

The cutting fluid may be provided on the exposed surface by means of at least one controllable nozzle.

The at least one controllable nozzle may be configured to apply the cutting fluid substantially over the entire surface of the top layer of the multialyer material, as seen when in use.

Alternatively, the at least one controllable nozzle may be configured to selectively provide the cutting fluid on the exposed surface in accordance with a pattern, which correlates to at least some of said predetermined portions of material that are to be removed from at least the first layer.

The at least one controllable nozzle can be configured to provide drops of the cutting fluid onto the exposed surface.

The at least one controllable nozzle may be an inkjet nozzle.

The at least one controllable nozzle may be a Drop-on-Demand (DOD)-nozzle, such as a DOD inkjet nozzle.

The at least one controllable nozzle may be movable in a X_{M}-direction (across the width of the multilayer material). For example, the at least one controllable nozzle may be attached to a holder extending across the width of the multilayer material. The at least one controllable nozzle may be movable along the holder. Alternatively, the at least one controllable nozzle may be attached to a holder which is movable across the width of the multilayer material.

As an alternative to the at least one controllable nozzle being movable, a plurality of nozzles may be fixedly mounted such as to cover the whole width of the multilayer material. As yet another alternative, a nozzle having a plurality of openings which covers the whole width of the multilayer material may be provided.

The at least one controllable nozzle may be controlled by a control unit. The control unit may be configured to control the position of the at least one nozzle based on input data. The input data may be image data, e.g. image data of a pattern, which correlates to said predetermined portions of material that are to be removed from at least the first layer. Further, the control unit may be configured to control the amount of cutting fluid provided onto the multilayer material. For example, the control unit may be configured to, based on said image data, control the frequency of drops provided onto the multilayer material from the at least one nozzle. Hence, the control unit can be configured to control where the cutting fluid is applied and/or the amount of cutting fluid applied to the exposed surface of the multilayer material.

The method may comprising controlling, by means of a control unit, the at least one controllable nozzle such that one first amount of cutting fluid is applied to a first portion of the exposed surface, and a second amount of cutting fluid is applied to another second portion of the exposed surface, the second amount of cutting fluid being different than the first amount of cutting fluid.

For example, one first amount of cutting fluid may be applied to one of said predetermined portions of material that are to be removed, and a second amount of cutting fluid may be applied to another one of said predetermined portions of material, the second amount of cutting fluid being different than the first amount of cutting fluid.

Hence, the cutting fluid provided on the exposed surface may be provided in a non-uniform manner as some areas of the predetermined portions of material that are to be removed may require a larger amount of cutting fluid than other areas.

Alternatively, the cutting fluid provided on the exposed surface may be provided in a uniform manner, i.e. the same amount of cutting fluid may be provided to all areas where the cutting fluid is to be applied.

The method may comprising controlling, by means of a control unit, the at least one controllable nozzle such that the cutting fluid is only provided on a plurality of edge portions of said predetermined portions of material that are to be removed.

The "edge portions" may constitute contours of the portions of material that are to be removed, and in particular bold contours.

The cutting fluid may be provided on the exposed surface by means of a plurality of nozzles, wherein at least one of said nozzles is configured to provide a first cutting fluid, and at least one other of said nozzles is configured to provide a second cutting fluid, different from the first cutting fluid.

A first cutting fluid transfer cylinder may be rotatably arranged to pick up the cutting fluid from a cutting fluid supply.

The first cutting fluid transfer cylinder may have a surface adapted to receive and hold an amount of cutting fluid.

The first cutting fluid transfer cylinder may be a cylinder of a metal material, a ceramic material and/or a polymer.

The first cutting fluid transfer cylinder may for example be provided in form of a ceramic-coated metal cylinder, such as an anilox roller.

The first cutting fluid transfer cylinder may be rotatably arranged to transfer the cutting fluid onto the multilayer material.

Thus, the cutting fluid can be provided on the exposed surface by means of the first cutting fluid transfer cylinder.

The first cutting fluid transfer cylinder may be arranged to provide a nip with said patterned cliché cylinder being arranged to cooperate with said milling cutter.

Thus, the first cutting fluid transfer cylinder may be arranged to cooperate with the patterned cliché cylinder which is arranged to cooperate with said milling cutter. The first cutting fluid transfer cylinder may be configured to rotate in an opposite direction as compared with the rotation direction of the patterned cliché cylinder.

Consequently, the cutting fluid may be provided on the exposed surface of the multilayer material in the form of a pattern substantially matching the pattern of said cliché cylinder being arranged to cooperate with said milling cutter.

The first cutting fluid transfer cylinder may be rotatably arranged to transfer the cutting fluid to a rotatable intermediate cylinder.

The intermediate cylinder may be formed of a metal material, a ceramic material and/or a polymer.

The intermediate cylinder may be configured to rotate in an opposite direction as compared with the rotation direction of the first cutting fluid transfer cylinder. The first cutting fluid transfer cylinder and the intermediate cylinder can be seen to be cooperately arranged.

The intermediate cylinder can be seen to be arranged between the first cutting fluid transfer cylinder and the multilayer material.

The intermediate cylinder may be rotatably arranged to transfer the cutting fluid onto the multilayer material.

Thus, the cutting fluid can be provided on the exposed surface by means of the intermediate cylinder.

The intermediate cylinder may be an unpatterned cylinder. I.e. the cylinder may present a substantially smooth surface.

Alternatively, the intermediate cylinder may be a patterned cylinder, such as a patterned cliché cylinder. The pattern may at least partly cover the surface of the patterned cylinder. The pattern may cover substantially the whole surface of the patterned cylinder.

The intermediate cylinder may be configured to apply the cutting fluid substantially over the entire surface of the top layer of the multialyer material, as seen when in use.

Alternatively, the intermediate cylinder may be configured to selectively provide the cutting fluid on the exposed surface in accordance with a pattern, which correlates to at least some of said predetermined portions of material that are to be removed from at least the first layer.

The intermediate cylinder may be a second patterned cliché cylinder.

Thus, a second patterned cliché cylinder may be rotatably arranged to transfer the cutting fluid onto the multilayer material. Consequently, the cutting fluid can be provided on the exposed surface by means of the second patterned cliché cylinder.

The second patterned cliché cylinder may be configured to rotate in an opposite direction as compared with the rotation direction of the cutting fluid transfer cylinder. The cutting fluid transfer cylinder and the second patterned cliché cylinder can be seen to be cooperately arranged.

The pattern of the second patterned cliché cylinder may substantially match the pattern of the patterned cliché cylinder which cooperates with the milling cutter. Thus, the cutting fluid can be provided precisely on said predetermined portions of material that are to be removed.

Alternatively, the pattern of the second patterned cliché cylinder may differ from the pattern of the patterned cliché cylinder which cooperates with the milling cutter. The pattern of the second patterned cliché cylinder may be slighly modified as compared with the pattern of the patterned cliché cylinder which cooperates with the milling cutter. Thus, the cutting fluid can be selectively applied such that the cutting fluid is only applied on a plurality of edge portions of said predetermined portions of material that are to be removed. A slightly modified pattern of the second patterned cliché cylinder also makes it possible to apply cutting fluid on a border area surrounding said predetermined portions of material that are to be removed.

As one alternative, the intermediate cylinder may be a second cutting fluid transfer cylinder.

The second cutting fluid transfer cylinder may have a surface adapted to receive and hold an amount of cutting fluid. Thus, the second cutting fluid transfer cylinder may be configured to transfer at least some of the cutting fluid picked up by the first cutting transfer cylinder onto the multilayer material.

The surface of the second cutting fluid transfer cylinder may be adapted to receive and hold a smaller amount of cutting fluid as compared with the first cutting fluid transfer cylinder. Thus, the second cutting fluid transfer cylinder may be configured to transfer only some of the cutting fluid picked up by the first cutting transfer cylinder onto the multilayer material. Alternatively, the surface of the second cutting fluid transfer cylinder may be adapted to receive and hold the same amount of cutting fluid as compared with the first cutting fluid transfer cylinder.

The second cutting fluid transfer cylinder may be seen to form an intermediate roller, i.e. a roller arranged between the first cutting fluid transfer cylinder and the multilayer material.

The second cutting fluid transfer cylinder may be an unpatterned cylinder.

The second cutting fluid transfer cylinder may be a cylinder of a metal material, a ceramic material and/or a polymer.

Further, a rotatable cylinder may be arranged to provide a nip with the intermediate cylinder such that the multilayer material is fed therebetween.

Said rotatable cylinder may be arranged to apply pressure on the multilayer material. Hence, it may be arranged to press the material towards the intermediate cylinder.

Said rotatable cylinder may be configured to rotate in an opposite direction as compared with the rotation direction of the intermediate cylinder.

The rotatable cylinder may be provided in form of an impression cylinder.

The intermediate cylinder may be arranged to provide a nip with said patterned cliché cylinder being arranged to cooperate with said milling cutter.

Thus, the intermediate cylinder may be arranged to cooperate with the patterned cliché cylinder which is arranged to cooperate with said milling cutter. The intermediate cylinder may be configured to rotate in an opposite direction as compared with the rotation direction of the patterned cliché cylinder.

Consequently, the cutting fluid may be provided on the exposed surface of the multilayer material in the form of a pattern substantially matching the pattern of said cliché cylinder being arranged to cooperate with said milling cutter.

According to a second aspect, there is provided a device for producing a product comprising a substrate with at least one patterned layer from a multilayer material, the device comprising: at least one milling cutter and at least one patterned cliché cylinder, wherein the at least one milling cutter is configured to, in use, cooperate with the at least one patterned cliché cylinder to form a nip, for removing, at least partially as seen in a thickness direction of a first layer of the multilayer material, predetermined portions of material from at least the first layer, in accordance with a pattern of the patterned cliché cylinder. The device further comprises at least one cutting fluid roll-to-roll processing arrangement for providing a cutting fluid on an exposed surface of the multilayer material.

The at least one cutting fluid roll-to-roll processing arrangement may be a cutting fluid printing arrangement.

Hence, the at least one cutting fluid roll-to-roll arrangement may be configured to print the cutting fluid on the exposed surface.

The at least one cutting fluid printing arrangement may for example be configured to print the cutting fluid on the exposed surface by inkjet printing, Drop-on-Demand (DOD)-printing, flexographic printing (flexography), offset printing, gravure printing and/or screen printing.

Alternatively, or additionally, the at least one cutting fluid roll-to-roll processing arrangement may be a cutting fluid coating arrangement.

Hence, the at least one cutting fluid roll-to-roll arrangement may be configured to coat the cutting fluid on the exposed surface.

The at least one cutting fluid coating arrangement may for example be configured to coat the cutting fluid on the exposed surface by slot die coating or blade coating.

Thus, the at least one cutting fluid roll-to-roll processing arrangement may be an inkjet printing arrangement, Drop-on-Demand-printing arrangement, flexographic printing arrangement, offset printing arrangement, gravure printing arrangement, screen printing arrangement, slot die coating arrangement and/or blade coating arrangement.

The cutting fluid roll-to-roll processing arrangement may be configured to selectively provide the cutting fluid on the exposed surface in accordance with a pattern, which correlates to at least some of said predetermined portions of material that are to be removed from at least the first layer.

The cutting fluid roll-to-roll processing arrangement may be configured to selectively provide the cutting fluid on the exposed surface in accordance with a 1 D-pattern, which correlates to at least some of said predetermined portions of material that are to be removed from at least the first layer.

The cutting fluid roll-to-roll processing arrangement may be configured to selectively provide the cutting fluid on the exposed surface in accordance with a 2D-pattern, which correlates to at least some of said predetermined portions of material that are to be removed from at least the first layer.

Alternatively, the cutting fluid roll-to-roll processing arrangement may be configured to provide the cutting fluid such as to cover a top layer of the multilayer material.

The cutting fluid roll-to-roll processing arrangement may comprise at least one controllable nozzle for providing a cutting fluid onto an exposed surface of the multilayer material.

The at least one controllable nozzle may be movably arranged, such that it is movable in a cross machine direction.

Thus, the at least one controllable nozzle may be movable across a width of the multilayer material. For example, the at least one nozzle may be movably arranged along a holder that is arranged to extend in a cross machine direction, i.e. across the width of the multilayer material as seen when in use. Alternatively, the at least one nozzle may be attached to a holder which is movable in the cross machine direction.

As one alternative, the at least one controllable nozzle may be fixedly arranged and comprise a plurality of openings for providing the cutting fluid.

The openings, i.e. orifices, may be distributed along a cross machine direction, i.e. across the width of the muntilayer material.

Further, the device may comprise a control unit configured to, in use, control the amount of cutting fluid provided from the at least one controllable nozzle and/or the position of the at least one controllable nozzle.

The control unit may for example be configured to, in use, control the frequency of drops provided onto the multilayer material from the at least one controllable nozzle.

Alternatively or additionally, the control unit can be configured to, in use, control the position of the at least one controllable nozzle along a cross machine direction, i.e. along a direction extending across the width of the multilayer material.

The cutting fluid roll-to-roll processing arrangement may comprise a rotatably arranged first cutting fluid transfer cylinder configured to, in use, pick up a cutting fluid from a cutting fluid supply.

The first cutting fluid transfer cylinder may be configured to, in use, transfer the cutting fluid onto the multilayer material.

Thus, the cutting fluid roll-to-roll processing arrangement may be seen to comprise a first cutting fluid transfer cylinder for providing a cutting fluid onto an exposed surface of the multilayer material when in use.

The first cutting fluid transfer cylinder may be configured to, in use, cooperate with said patterned cliché cylinder to form a nip.

The cutting fluid roll-to-roll processing arrangement may comprise a rotatably arranged intermediate cylinder.

The intermediate cylinder can be seen to be arranged between the first cutting fluid transfer cylinder and the multilayer material.

The first cutting fluid transfer cylinder may be configured to, in use, transfer the cutting fluid to the intermediate cylinder.

The intermediate cylinder may be configured to, in use, transfer the cutting fluid onto the multilayer material.

Thus, the cutting fluid roll-to-roll processing arrangement may be seen to comprise an intermediate cylinder for providing a cutting fluid onto an exposed surface of the multilayer material when in use.

The intermediate cylinder may be a second patterned cliché cylinder.

A first pattern of the patterned cliché cylinder which is configured to cooperate with the milling cutter may substantially match a second pattern of the second patterned cliché cylinder. Alternatively, a first pattern of the patterned cliché cylinder which is configured to cooperate with the milling cutter may be different than a second pattern of the second patterned cliché cylinder.

As one alternative, the intermediate cylinder may be a second cutting fluid transfer cylinder.

The cutting fluid roll-to-roll processing arrangement may comprise a rotatable cylinder which is arranged to provdie a nip with the intermediate cylinder for feeding the multilayer material therebetween.

The intermediate cylinder may be arranged to provide a nip with said patterned cliché cylinder being arranged to cooperate with said milling cutter.

Consequently, according to the above, the cutting fluid roll-to-roll processing arrangement may be seen to comprise at least one of the following: at least one controllable nozzle, at least one first cutting fluid transfer cylinder, such as for example an anilox roller, at least one intermediate cylinder which can be a patterned cylinder or an unpatterned cylinder (for example a cliché cylinder or a second cutting fluid transfer cylinder), at least one cliché cylinder, and/or at least one rotatable cylinder, such as for example an impression roller.

### Brief Description of the Drawings

Embodiments of the present solution will now be described, by way of example, with reference to the accompanying schematic drawings in which:
Fig. 1a schematically illustrates a patterned multilayer material comprising a first layer and a second layer.
Fig. 1b schematically illustrates a patterned multilayer material comprising a cover layer, a first layer, and a second layer.
Fig. 1c schematically illustrates a patterned multilayer material comprising a first layer, an intermediate dielectric layer, a conductive layer, and a second layer.
Fig. 1d schematically illustrates a patterned multilayer material comprising a first layer, a second layer and a conductive layer.
Fig. 1e schematically illustrates one embodiment of a first layer of the multilayer material.
Fig. 1f schematically illustrates another embodiment of a first layer of the multilayer material.
Figs. 2a-2b schematically illustrate one embodiment of a device for producing a product comprising a substrate with at least one patterned layer from a multilayer material.
Figs. 3a-3b schematically illustrate another embodiment of a device for producing a product comprising a substrate with at least one patterned layer from a multilayer material.
Fig. 4a schematically illustrates yet another embodiment of a device for producing a product comprising a substrate with at least one patterned layer from a multilayer material.
Fig. 4b schematically illustrates yet another embodiment of a device for producing a product comprising a substrate with at least one patterned layer from a multilayer material.
Fig. 5 illustrates a cliché cylinder.

### Detailed description

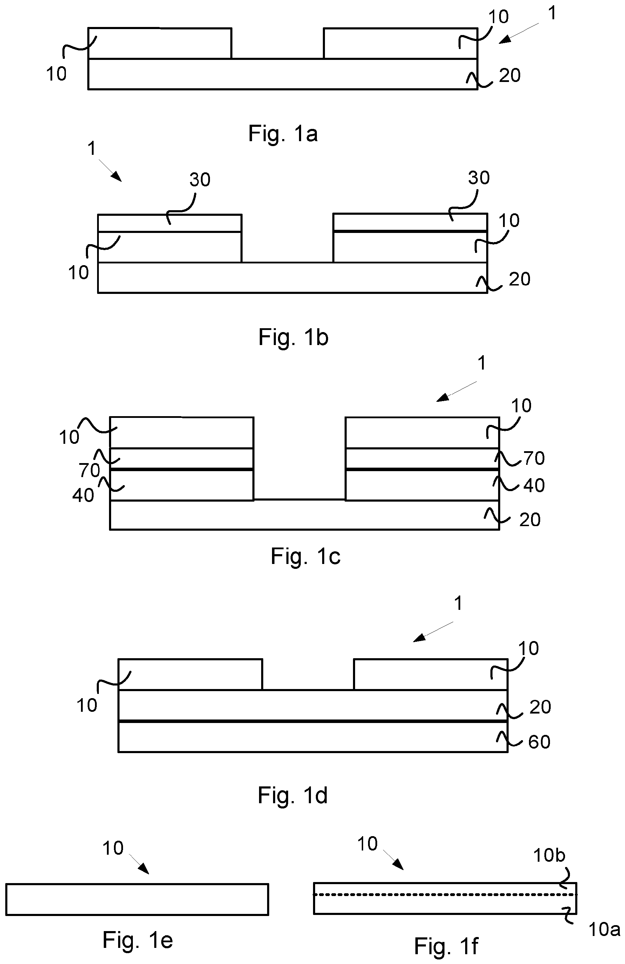

In relation to Figs. 1-4, a method for producing a product comprising a substrate with at least one patterned layer will be described.

The method comprises providing a multilayer material 1 comprising at least a first layer 10 and a second layer 20.

Figs. 1a-1d illustrate different embodiments of a multilayer material 1 that has been provided with a pattern in accordance with the method. As illustrated, the multilayer material 1 can comprise a plurality of layers 10, 20, 30, 40, 60, 70.

As illustrated in Figs. 1a-1d, the multilayer material 1 comprises at least a first layer 10 and a second layer 20.

The multilayer material 1 is a flexible material. For example, the multilayer material 1 may be provided in form of a foil or a film.

The flexible material may be provided in form of a continious web or in form of a sheet. Thus, the multilayer material may be provided from a material supply such as a web unwinding roll (not illustrated) or a supply holding a plurality of sheets (not illustrated).

The second layer 20 of the multilayer material 1 may be seen to form a substrate layer or a bottom carrier layer. The second layer 20 may be formed of a dielectric material. For example, the second layer may be formed of a plastic material or paper. The second layer may be formed of Polyethylene terephthalate (PET), Polycarbonate (PC), Polyimide (PI), Polyethylene naphtalate (PEN) or paper. The second layer may have a thickness of about 20-200 µm, 20-150 µm or 20-100 µm, preferably 20-90 µm or 30-80 µm, more preferably 35-75 µm or 45-65 µm.

As illustrated in Figs. 1a, 1c and 1d, the first layer 10 of the multilayer material 1 may be seen to form a top layer that is to be provided with a structure or pattern. Alternatively, the first layer 10 may be seen to form an intermediate layer, such as for example a layer formed between the second layer 20 and a cover layer 30 as illustrated in Fig. 1b.

The first layer 10 may be formed of a conductive material. The first layer 10 may be formed of one or several metals, a metal alloy or a polymer. The first layer 10 may for example be formed of Aluminum (Al), Copper (Cu), Copper Cladded Aluminum (CCA), Tin (Sn), Gold (Au), Silver (Ag), Nickel (Ni), Carbon (C), or an alloy thereof, such as a Copper alloy or Copper-Nickel alloy.

As illustrated in Fig. 1e, the first layer 10 may be formed of one metal, metall alloy or a polymer. As illustrated in Fig. 1f, the first layer may be formed of at least two different metals, for example two different metals presenting different characteristics. Thus, as illustrated in Fig. 1f, the first layer 10 may be seen to comprise at least a first sublayer 10a of a first metal and a second sublayer 10b of a second metal. The first and second sublayers 10a, 10b may present the same or different thicknesses. For example, in the case of the first layer 10 being formed of CCA, the first sublayer 10a can be seen to be formed of Aluminium (Al) and the second sublayer 10b can be seen to be formed of Copper (Cu). In such case, the first sublayer 10a is preferably thicker than the second sublayer 10b.

The first layer 10 may have a thickness of about 5-150 µm, 5-100 µm, 5-75 µm, 5-40 µm, 9-30 µm or 10-20 µm. According to some embodiments, the first layer 10 may have a thickness of of more than 40 µm, preferably 40-150 µm or 40-100 µm, more preferably 40-90 µm, 50-80 µm or 60-70 µm.

As one example, the first layer 10 may be an aluminium layer having a thickness of more than 40 µm. As another example, the first layer 10 may be a copper layer having a thickness of more than 10 µm.

The first layer may be seen to be formed of a material that presents difficulties in machinability. The first layer 10 may have a machinability value, measured as specific cutting force k_{c1}, of more than 300 N/mm², preferably more than 500 N/mm², more preferably more than 700 N/mm².

As illustrated in Fig. 1b, the multilayer material 1 may further comprise at least one cover layer 30 covering at least a portion of a first surface of the first layer 10. The first surface can be seen to form a top surface of the first layer 10. The first surface of the first layer 10 is opposite to a second surface of the first layer. The second surface can be seen to face the second layer 20 of the multilayer material 1, or another underlying layer. The at least one cover layer 30 may be formed of a dielectric material. The thickness of the cover layer 30 is preferably smaller than the thickness of the first layer 10.

As one example, the multilayer material 1 may comprise a second layer 20 in form of a substrate, a first layer 10 formed of a conductive material, and a cover layer 30.

The multilayer material 1 may further comprise at least one additional conductive layer 40, 60. The at least one additional conductive layer 40, 60 may be formed of one or several metals, a metal alloy or a polymer. The at least one additional conductive layer 40, 60 may be formed of Aluminum (Al), Copper (Cu), Copper Cladded Aluminum (CCA), Tin (Sn), Gold (Au), Silver (Ag), Nickel (Ni), Carbon (C), or an alloy thereof, such as a Copper alloy or Copper-Nickel alloy. The at least one additional conductive layer 40, 60 may be formed of the same material as the first layer 10, or a different material.

The at least one additional conductive layer 40, 60 may have substantially the same thickness as the first layer 10, or a different thickness. The additional conductive layer 40, 60 may have a smaller thickness than the first layer 10. Alternatively, the additional conductive layer 40, 60 may have a greater thickness than the first layer 10.

As illustrated in Fig. 1c, the multilayer material 1 may comprise an intermediate conductive layer arranged between the first layer 10 and the second layer 20. The multilayer material 1 may further comprise an intermediate dielectic layer 70. Thus, as illustrated in Fig. 1c, the at least one additional conductive layer 40 may provided as an intermediate conducitve layer sandwhiched between the second layer 20 and the intermediate dielectric layer 70.

As one example, the multilayer material 1 may comprise a second layer 20 in form of a substrate forming a bottom layer, a first layer 10 formed of a conductive material forming a top layer, an additional conductive layer 40, and an intermediate dielectric layer 70 formed between the first layer 10 and the additional conductive layer 40.

As illustrated in Fig. 1d, the multilayer material 1 may comprise an additional conductive layer 60. As illustrated, the conductive layer 60 may be arranged on an opposite side of the second layer 20, as compared with the first layer 10. Thus, the second layer 20 can be seen to be arranged between the first layer 10 and the additional conductive layer 60. The first layer 10 and the conductive layer 60, may present identical layers or different layers. Thus, the first layer 10 and the conductive layer 60 may be formed of the same material and/or have the same thickness.

As one example, the multilayer material 1 may comprise a second layer 20 in form of a substrate, a first layer 10 formed of a conductive material, and an additional condcutive layer 60, wherein the first layer 10 and the conducitve layer 60 is arranged on opposite sides of the substrate.

Further, although not illustrated, the multilayer material 1 may comprise at least one adhesive layer. An adhesive may be provided between each layer, or between at least two adjacent layers. For example, at least one adhesive layer may be provided between the first and second layers 10, 20. Alternatively, or additionally, at least one adhesive layer may be provided between the first layer 10 and the cover layer 30. Alternatively, or additionally, at least one adhesive layer may be provided between the first layer 10 and the intermediate dielectric layer 70. Alternatively, or additionally, at least one adhesive layer may be provided between the intermediate dielectric layer 70 and the additional conductive layer 40. Alternatively, or additionally, at least one adhesive layer may be provided between the second layer 20 and the additional conductive layer 40. Alternatively, or additionally, at least one adhesive layer may be provided between the second layer 20 and the additional conductive layer 60.

Although not illustrated, it is understood that other multilayer materials than the ones illustrated in Figs. 1a-1d is possible. For example, the multilayer material 1 as illustrated in Fig. 1c and 1d may further comprise a cover layer. Further, a multilayer material as illustrated in Fig. 1c may be provided with additional conductive layers and/or dielectric layers.

The method further comprises passing the multilayer material 1 through at least one nip 6. Said nip 6 is provided by a milling cutter 51 cooperating with a patterned cliché cylinder 52. The multilayer material 1 is passed through at least one nip 6 to at least partially, as seen in a thickness direction of the first layer 10, remove at least some predetermined portions of material from at least the first layer 10 of the multilayer material 1.

Thus, the multilayer material is passed through at least one nip 6 to selectively remove at least some predetermined portions of material from at least the first layer 10 of the multilayer material 1, in accordance with a pattern of the patterned cliché cylinder 52, whereby the patterned layer is formed from the first layer 10.

The removal of the predetermined portions of material from the first layer 10 may be performed in one or in several subsequent milling steps. For each milling step, the multilayer material 1 can be passed through one nip. Thus, the multilayer material may be passed through one nip, provided by one and the same milling cutter and patterned cliché cylinder, more than once. As another alternative, the multilayer material may be passed through several subsequent nips. Consequently, the multilayer material 1 may be passed through one or several milling cutters and one or several cooperating cliché cylinders.

In the case that the removal of predetermined portions of material are performed in several milling steps, the removal of the predetermined portions of material from the first layer 10 may be performed partially in one or several first milling steps and be completed in a subsequent milling step. After the final milling step, at least the first layer 10 has been cut through and predetermined portions of material have been removed from the first layer 10, such that at least a portion of an adjacent, underlying layer of the multilayer material 1 is exposed. Thus, a pattern can be seen to be formed in at least the first layer 10 of the multilayer material 1.

Milling in several steps may for example be advantageous when the first layer 10 have a thickness of of more than 40 µm and/or when the first layer 10 is formed of a material that presents difficulties in machinability.

The method further comprises providing a cutting fluid 8 on an exposed surface of the multilayer material 1. The cutting fluid may be provided in form of a lubricant. Any suitable lubricant may be used. For example, the lubricant may be an alcohol, a fatty alchol, oil, water, tensides or a blend of a plurality of these substances.

The cutting fluid may be provided onto the multilayer material 1 before milling. Hence, the step of providing a cutting fluid 8 on an exposed surface of the multilayer material 1 may be performed prior to the step of passing the multilayer material 1 through at least one nip 6.

In the case that the removal are performed in several milling steps, a cutting fluid 8 may alternatively or additionally be applied inbetween two subsequent milling steps.

Further, the method comprises providing said cutting fluid 8 on the exposed surface 15 by roll-to-roll processing the cutting fluid 8 on the exposed surface.

The roll-to-roll processing may comprise printing the cutting fluid 8 on the exposed surface 15. For example, the roll-to-roll processing may comprise inkjet printing, Drop-on-Demand-printing, flexographic printing, offset printing, gravure printing and/or screen printing the cutting fluid 8 on the exposed surface 15.

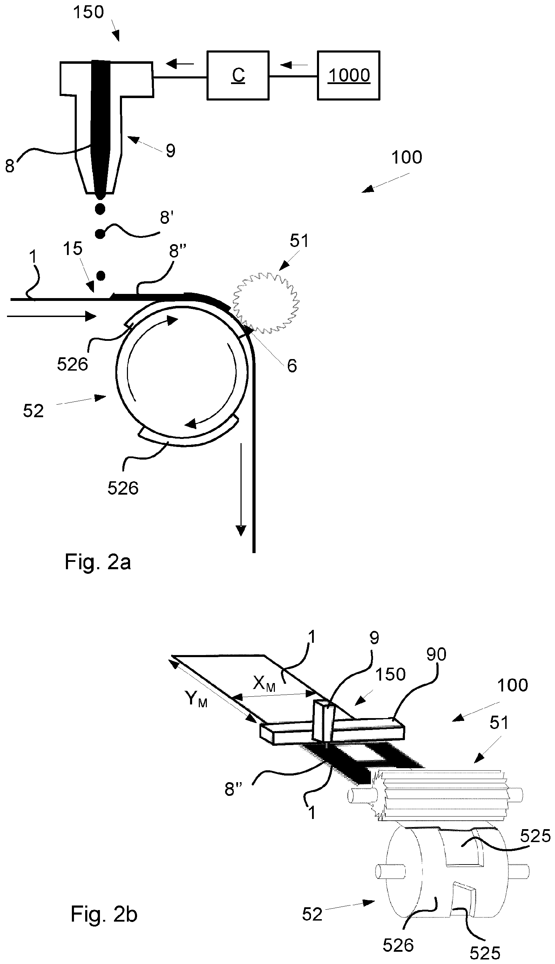

Figs. 2-4 illustrates various examples of printing the cutting fluid on the exposed surface. However, it is understood that other embodiments of roll-to-roll processing are also possible. For example, the roll-to-roll processing may comprises coating the cutting fluid 8 on the exposed surface 15. For example, the roll-to-roll processing may comprise slot die coating and/or blade coating the cutting fluid 8 on the exposed surface 15.

The cutting fluid 8 may be provided on substantially the entire surface of a top layer of the multilayer material 1, as seen when in use. Alternatively, the cutting fluid 8 may be provided on selected portions of the multilayer material 1.

Thus, the method may comprise selectively providing said cutting fluid 8 on the exposed surface in accordance with a pattern, which correlates to at least some of said predetermined portions of material that are to be removed from at least the first layer 10. Said cutting fluid may be selectively provided on the exposed surface in accordance with a 1D-pattern. Alternatively, said cutting fluid may be selectively provided on the exposed surface in accordance with a 2D-pattern.

Hence, according to the method, a cutting fluid may be provided onto the multilayer material in form of a pattern. The pattern is correlated to predetermined portions of material that are to be removed from at least the first layer 10 of the multilayer material 1. The pattern may substantially match the pattern of said cliché cylinder 52. Alternatively, the pattern may differ from the pattern of said cliché cylinder 52. For example, the pattern may be slightly modified, such as relatively enlarged, reduced or displaced as compared with the pattern of said cliché cylinder.

The method may comprise providing an amount of 0.01-15 g of cutting fluid per m² of the exposed surface of the multilayer material. Preferably 0.1-10 g/m² or 0.2-5 g/m², more prefearbly 0.3-1 g/m² or 0.4-0.6 g/m².

In some embodiments, a cutting fluid 8 may be provided on an exposed surface of the multilayer material 1 in an amount of 0.01-0.05 g/m², 0.05-0.1 g/m², 0.1-0.2 g/m², 0.2-0.3 g/m², 0.3-0.4 g/m², 0.4-0.5 g/m², 0.5-0.6 g/m², 0.6-0.7 g/m², 0.7-0.8 g/m², 0.8-0.9 g/m², 0.9-1 g/m², 1-2 g/m², 2-3 g/m², 3-4 g/m², 4-5 g/m², 5-6 g/m², 6-7 g/m², 7-8 g/m², 8-9 g/m² or 9-10 g/m², 10-11 g/m², 11-12 g/m², 12-13 g/m², 13-14 g/m², or 14-15 g/m².

As illustrated in Figs. 2a-2b, the cutting fluid 8 may be provided on the exposed surface by means of at least one controllable nozzle 9. The at least one controllable nozzle 9 may be configured to provide drops of the cutting fluid 8' onto the exposed surface.

The at least one controllable nozzle 9 may be configured to dispense cutting fluid continiously. Alternatively, the at least one controllable nozzle 9 may be configured to dispense cutting fluid discontinously.

The at least one controllable nozzle 9 may be an inkjet nozzle.

As one example, the at least one controllable nozzle may be a Drop-on-Demand (DOD)-nozzle, such as a DOD inkjet nozzle. Thus, the at least one controllable nozzle 9 may be configured to only dispense cutting fluid when required. Such DOD-nozzle can be seen to dispense cutting fluid discontiniously.

Consequently, the method may comprise providing the cutting fluid on the exposed surface of the multilayer material 1 by means of inkjet printing. In such case, drops of cutting fluid is provided onto the multilayer material 1. I.e. instead of drops of ink, drops of cutting fluid is provided.

Further, the method may comprise providing the cutting fluid on the exposed surface of the multilayer material 1 by means of Drop on Demand (DOD)-printing.

As illustrated in Fig. 2b, the Y_{M}-direction extends along a length of the multilayer material 1. The at least one controllable nozzle 9 may be movable in a Xnn-direction, i.e. across the width of the multilayer material 1, see Fig. 2b. For example, the at least one controllable nozzle 9 may be attached to a holder 90 extending in a cross machine direction, i.e. across the width of the multilayer material 1, see Fig. 2b. The at least one controllable nozzle 9 may be movable along the holder 90. Alternatively, the at least one controllable nozzle 9 may be attached to a holder which is movable across the width of the multilayer material 1. Thus, the method may comprise moving the at least on nozzle 9 in a cross machine direction while providing cutting fluid 8' onto the multilayer material 1.

As an alternative to the at least one controllable nozzle 9 being movable, a plurality of nozzles (not illustrated) may be fixedly mounted such as to cover the whole width of the multilayer material 1. As yet another alternative, a nozzle having a plurality of openings (not illustrated) which covers the whole width of the multilayer material 1 may be provided.

The at least one controllable nozzle 9 may be controlled by a control unit C, see Fig. 2a. Thus, the method may comprise controlling the at least one controllable nozzle 9 by means of a control unit C. The at least one controllable nozzle 9 may be controlled based on input data 1000. The input data 1000 may be image data, e.g. image data of a pattern, which correlates to said predetermined portions of material that are to be removed from at least the first layer 10.

Thus, the at least one nozzle 9 may be controlled by the control unit C to selectively provide said cutting fluid 8 on the exposed surface in accordance with a pattern. The pattern may substantially match the pattern of said cliché cylinder 52. Alternatively, the pattern may differ from the pattern of said cliché cylinder 52. For example, the pattern may be slightly modified, such as relatively enlarged, reduced or displaced as compared with the pattern of said cliché cylinder.

Alternatively, the at least one nozzle 9 may be controlled by the control unit C to provide said cutting fluid 8 onto substantially the entire top surface of the multilayer material 1, as seen when in use.

The control unit C may be configured to control the position of the at least one nozzle 9. The control unit C may be configured to control the position of the at least one nozzle 9 based on the input data 1000, e.g. image data of a pattern, which correlates to said predetermined portions of material that are to be removed from at least the first layer 10.

Alternatively, or additionally, the control unit C may be configured to control the amount of cutting fluid 8 provided onto the multilayer material 1. For example, the control unit C may be configured to, based on said input data 1000, control the frequency of drops provided onto the multilayer material 1 from the at least one nozzle 9.

Hence, the control unit C can be configured to control where the cutting fluid 8' is applied. Alternatively or additionally, the control unit C can be configured to control the amount of cutting fluid 8' applied to the exposed surface of the multilayer material 1.

Further, the method may comprise controlling, by means of the control unit C, the at least one controllable nozzle 9 such that one first amount of cutting fluid 8 is applied to a first portion of the exposed surface of the multilayer material 1. Further, the method may comprise controlling, by means of the control unit C, the at least one controllable nozzle 9 such that a second amount of cutting fluid 8 is applied to another second portion of the exposed surface. The second amount of cutting fluid may be the same as the first amount of cutting fluid. Alternatively, the second amount of cutting fluid may be different than the first amount of cutting fluid.

For example, the method may comprise controlling, by means of the control unit C, the at least one controllable nozzle 9 such that one first amount of cutting fluid 8 is applied to one of said predetermined portions of material that are to be removed. The method may further comprise controlling, by means of the control unit C, the at least one controllable nozzle 9 such that a second amount of cutting fluid 8 is applied to another one of said predetermined portions of material. The second amount of cutting fluid may be the same, or different than the first amount of cutting fluid.

Hence, the cutting fluid provided on the exposed surface may be provided in a non-uniform manner as some areas of the predetermined portions of material that are to be removed may require a larger amount of cutting fluid than other areas.

Alternatively, the cutting fluid provided on the exposed surface may be provided in a uniform manner, i.e. the same amount of cutting fluid may be provided to all areas where the cutting fluid is applied.

Further, the method may comprise controlling, by means of the control unit C, the at least one controllable nozzle 9 such that the cutting fluid 8' is only provided on a plurality of edge portions of said predetermined portions of material that are to be removed.

Further, although not illustrated, a pluarlity of nozzles 9 may be provided. In such case, the cutting fluid 8' may be provided on the exposed surface by means of a plurality of nozzles. One of said plurality of nozzles may configured to provide a first cutting fluid. Another one of said plurality of nozzles may be configured to provide a second cutting fluid. The second cutting fluid may be the same as the first cutting fluid. Alternatively, the second cutting fluid may be different from the first cutting fluid.

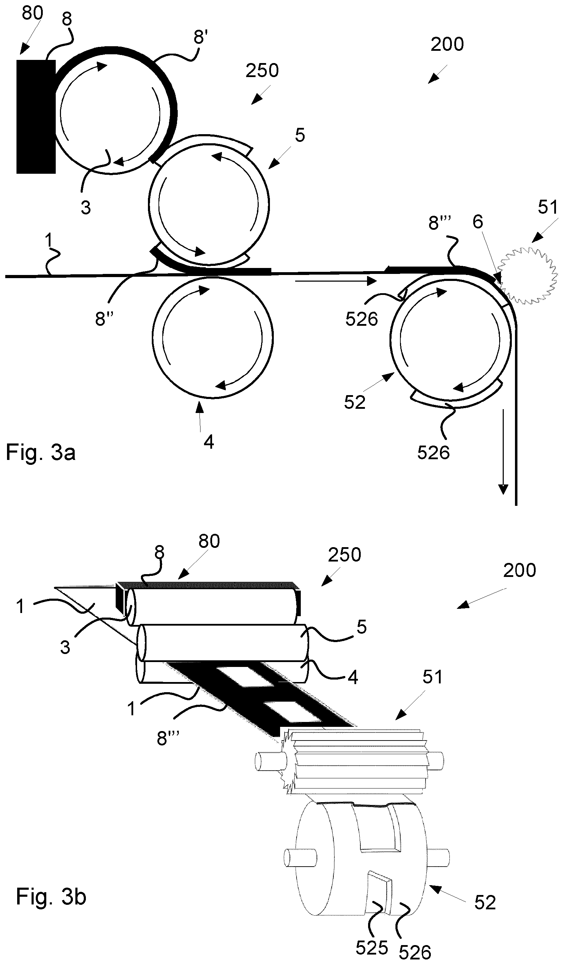

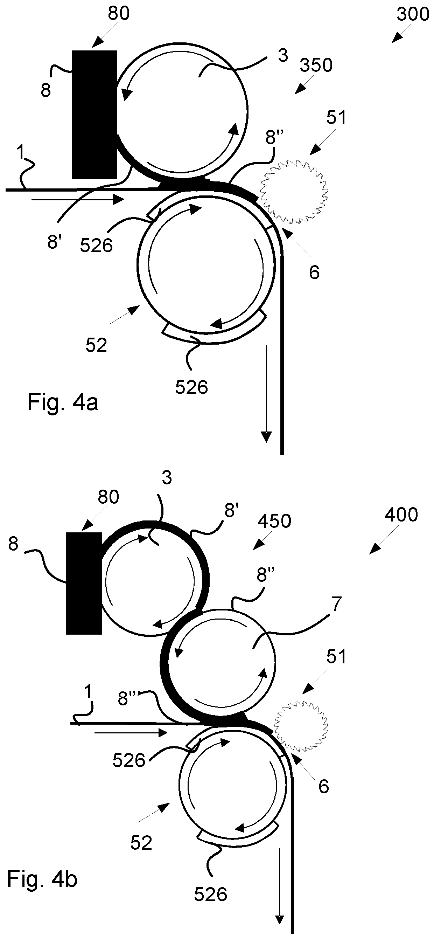

As illustrated in Figs. 3a-3b, Fig. 4a and Fig. 4b, the method may comprise picking up cutting fluid 8' from a cutting fluid supply 80. The cutting fluid supply may be arranged to hold a cutting fluid 8. For example, a first cutting fluid transfer cylinder 3 may be rotatably arranged to pick up the cutting fluid 8' from the cutting fluid supply 80.

The first cutting fluid transfer cylinder 3 may have a surface adapted to receive and hold an amount of cutting fluid 8'.

The first cutting fluid transfer cylinder 3 may be a cylinder of a metal material, a ceramic material and/or a polymer.

The first cutting fluid transfer cylinder 3 may for example be provided in form of a ceramic-coated metal cylinder, such as an anilox roller.

Further, the first cutting fluid transfer cylinder 3 may be rotatably arranged to transfer the cutting fluid 8" to a rotatable intermediate cylinder.

Figs. 3a-3b illustrate one example of an intermediate cylinder in form of a second patterned cliché cylinder 5.

Fig. 4b illustrate another example of an intermediate cylinder in form of a second cutting fluid transfer cylinder 7.

As illustrated in Fig. 3a-3b, the first cutting fluid transfer cylinder 3 may be rotatably arranged to transfer the cutting fluid 8" to a second patterned cliché cylinder 5. Thus, the method may comprise transferring cutting fluid 8" from the first cutting fluid transfer cylinder 3 to the second patterned cliché cylinder 5.

During the transfer, the second patterned cliché cylinder 5 may rotate in an opposite direction as compared with the rotation direction of the first cutting fluid transfer cylinder 3.

Further, as illustrated in Figs. 3a-3b, the second patterned cliché cylinder 5 may be rotatably arranged to transfer the cutting fluid 8‴ onto the multilayer material 1. Thus, the method may comprise transferring cutting fluid 8‴ from the second patterned cliché cylinder 5 to the multilayer material 1. I.e. the cutting fluid can be provided on the exposed surface of the multilayer material 1 by means of the second patterned cliché cylinder 5.

The pattern of the second patterned cliché cylinder 5 may substantially match the pattern of the patterned cliché cylinder 52 which cooperates with the milling cutter 51. Thus, the cutting fluid 8‴ can be provided precisely on said predetermined portions of material that are to be removed.

Alternatively, the pattern of the second patterned cliché cylinder 5 may differ from the pattern of the patterned cliché cylinder 52 which cooperates with the milling cutter 51. The pattern of the second patterned cliché cylinder 5 may be slighly modified as compared with the pattern of the patterned cliché cylinder 52 which cooperates with the milling cutter 51. For example, the pattern may be slightly modified, such as relatively enlarged, reduced or displaced as compared with the pattern of the clich6 cylinder 52. For example, the cutting fluid can be selectively applied, such that the cutting fluid 8‴ is only applied on a plurality of edge portions of said predetermined portions of material that are to be removed. A slightly modified pattern of the second patterned cliché cylinder 5 also makes it possible to apply cutting fluid 8‴ on a border area surrounding said predetermined portions of material that are to be removed.

The method may comprise registering the cliché cylinders 52, 5 relative one another in X-driection and Y-direction. Further, a registration of a rotational angle θ of the cliché cylinders may be performed.

Further, as illustrated in Figs. 3a-3b, a rotatable cylinder 4 may be arranged in cooperation with the second patterned cliché cylinder 5 such that the multilayer material 1 can be fed therebetween. Said rotatable cylinder 4 may be arranged to apply pressure on the multilayer material 1. Hence, it may be arranged to press the material 1 towards the second patterned cliché cylinder 5. Thus, the method may comprise transferring cutting fluid 8‴ from the second patterned cliché cylinder 5 to the multilayer material 1 while applying a pressure on the multilayer material 1. During the transfer, the rotatable cylinder 4 may rotate in an opposite direction as compared with the rotation direction of the second patterned cliché cylinder 5.

The rotatable cylinder 4 may be provided in form of an impression cylinder.

As illustrated in Fig. 4a, the first cutting fluid transfer cylinder 3 may be rotatably arranged to transfer the cutting fluid 8" onto the multilayer material 1. Thus, the method may comprise transferring cutting fluid 8" from the first cutting fluid transfer cylinder 3 to the multilayer material 1. I.e. the cutting fluid can be provided on the exposed surface of the multilayer material 1 by means of the first cutting fluid transfer cylinder 3.

As illustrated in Fig. 4a, the first cutting fluid transfer cylinder 3 may be arranged to cooperate with the patterned cliché cylinder 52 which is arranged to cooperate with said milling cutter 51. The first cutting fluid transfer cylinder 3 may be arranged such that a nip is formed between the first cutting fluid transfer cylinder 3 and the clich6 cylinder 52. During the transfer of the cutting fluid 8" from the first cutting fluid transfer cylinder 3 to the multilayer material 1, the first cutting fluid transfer cylinder 3 may rotate in an opposite direction as compared with the rotation direction of the patterned cliché cylinder 52.

As illustrated in Fig. 4b, the first cutting fluid transfer cylinder 3 may be rotatably arranged to transfer the cutting fluid 8" to a rotatable intermediate cylinder in form of a second cutting fluid transfer cylinder 7. Thus, the method may comprise transferring cutting fluid 8" from the first cutting fluid transfer cylinder 3 to a second cutting fluid transfer cylinder 7.

During the transfer, the second cutting fluid transfer cylinder 7 may rotate in an opposite direction as compared with the rotation direction of the first cutting fluid transfer cylinder 3. As illustrated in Fig. 4b, the second cutting fluid transfer cylinder 7 can be seen to be arranged between the first cutting fluid transfer cylinder 3 and the multilayer material 1.

The second cutting fluid transfer cylinder 7 may be seen to form an intermediate roller, i.e. a roller arranged between the first cutting fluid transfer cylinder 3 and the multilayer material 1.

The second cutting fluid transfer cylinder 7 may be a cylinder of a metal material, a ceramic material and/or a polymer.

The second cutting fluid transfer cylinder 7 may be an unpatterned cylinder.

Further, at least a surface of the second cutting fluid transfer cylinder 7 may be formed of a material which is harder than a material forming at least a surface of the first cutting fluid transfer cylinder 3, as measured by Vickers hardness test. Thus, the Vickers number (HV) of a material formig at least a surface of the second cutting fluid transfer cylinder 7 may be higher than the Vickers number (HV) of a material forming at least a surface of the first cutting fluid transfer cylinder 3. Alternatively, at least a surface of the second cutting fluid transfer cylinder 7 may be formed of a material which is softer than a material forming at least a surface of the first cutting fluid transfer cylinder 3, as measured by Vickers hardness test. Alternatively, at least a surface of the second cutting fluid transfer cylinder 7 may be formed of a material which is substantially equally hard as a material forming at least a surface of the first cutting fluid transfer cylinder 3, as measured by Vickers hardness test.

Further, a material forming at least a surface of the first cutting fluid transfer cylinder 3 may present a first elasticity. A material forming at least a surface of the second cutting fluid transfer cylinder 7 may present a second elasticity. The first elasticity and the second elasticity may differ. Alternatively, the first elasticity and the second elasticity may be the same or essentially the same.

As illustrated in Fig. 4b, the second cutting fluid transfer cylinder 7 may be rotatably arranged to transfer the cutting fluid 8‴ onto the multilayer material 1. Thus, the method may comprise transferring cutting fluid 8'" from the second cutting fluid transfer cylinder 7 to the multilayer material 1. I.e. the cutting fluid 8‴ can be provided on the exposed surface of the multilayer material 1 by means of the second cutting fluid transfer cylinder 7.

As illustrated in Fig. 4b, the second cutting fluid transfer cylinder 7 may be arranged to cooperate with the patterned cliché cylinder 52 which is arranged to cooperate with said milling cutter 51. The second cutting fluid transfer cylinder 7 may be arranged such that a nip is formed between the second cutting fluid transfer cylinder 7 and the clich6 cylinder 52. During the transfer of the cutting fluid 8‴ from the second cutting fluid transfer cylinder 7 to the multilayer material 1, the second cutting fluid transfer cylinder 7 may rotate in an opposite direction as compared with the rotation direction of the patterned cliché cylinder 52.

Thus, the method may comprise providing the cutting fluid on the exposed surface of the multilayer material 1 by means of inkjet printing and/or Drop-On-Demand (DOD)-printing, for example as illustrated in Figs. 2a-2b.

Alternatively, or additionally, the method may comprise providing the cutting fluid on the exposed surface of the multilayer material 1 by means of flexography, for example as illustrated in Figs. 3a-3b.

Alternatively, or additionally, the method may comprise providing the cutting fluid on the exposed surface of the multilayer material 1 by means of offset printing (not illustrated).

Alternatively, or additionally, the method may comprise providing the cutting fluid on the exposed surface of the multilayer material 1 by means of gravure printing (not illustrated).

Alternatively, or additionally, the method may comprise providing the cutting fluid on the exposed surface of the multilayer material 1 by means of screen printing (not illustrated).

Alternatively, or additionally, the method may comprise providing the cutting fluid on the exposed surface of the multilayer material 1 by means of slot-die coating (not illustrated).

Alternatively, or additionally, the method may comprise providing the cutting fluid on the exposed surface of the multilayer material 1 by means of blade coating (not illustrated).

Although not illustrated, it is understood that other embodiments of cutting fluid roll-to-roll processing arrangements than the ones illustrated in Figs. 2-4, may be used for providing said cutting fluid on the exposed surface of the multilayer material 1.

For example, as an alternative of providing an intermediate cylinder in form of a second patterned cliché cylinder in the arrangement of Fig. 3a, an intermediate cylinder in form of an unpatterned cylinder may be provided instead. As one example, a second cutting fluid transfer cylinder 7, as the one illustrated in Fig. 4b, may be provided in the arrangement of Fig. 3a instead of the second patterned cliché cylinder.

Further, various combinations of the cutting fluid roll-to-roll processing arrangements 150, 250, 350, 450 as illustrated and described in relation to Figs. 2-4 may be provided. Hence, more than one cutting fluid roll-to-roll processing arrangement may be used for providing the cutting fluid. The plurality of cutting fluid roll-to-roll processing arrangements may be designed essentially the same, or differently. The plurality of cutting fluid roll-to-roll processing arrangements may be configured essentially the same, or differently. A plurality of cutting fluid roll-to-roll processing arrangements may for example be advantageous if the device is to be used for several subsequent milling steps.

In relation to Figs. 2-5, a device 100, 200, 300, 400 for producing a product comprising a substrate with at least one patterned layer will be described. The device 100, 200, 300, 400 may be used in a method as described above.

As illustrated in Figs. 2-4, the device 100, 200, 300, 400 comprises at least one milling cutter 51 and at least one patterned cliché cylinder 52.

As illustrated in Figs. 2a, 3a, 4a and 4b, the device 100, 200, 300, 400 is configured to, in use, provide at least one nip 6. The nip 6 is formed by a patterned cliché cylinder 52 and a cooperating milling cutter 51.

The at least one milling cutter 51 can be provided in form of a milling cylinder. The milling cutter may be provided in form of a cylindrical milling wheel, with cutting teeth running along an axial direction of an envelope surface of the cylinder, such as helically or straight along the axial direction. Figs. 2-4 illustrates one example of a milling cylinder 51. However, it is understood that other embodiments are possible.

Although not illustrated, the device 100, 200, 300, 400 may comprise multiple milling cutters. For example, multiple milling cutters may be provided in such case the device is to be used for removal of predetermined portions of material in several subsequent milling steps. The multiple mililing cutters may be designed identically, substantially the same, or differently. For example a diameter of the multiple milling cylinders may be the same or different. As another example, the size and/or number of teeth of the milling cylinders, may be the same or different.

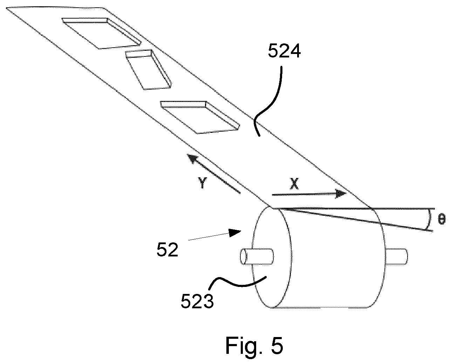

The at least one patterned clich6 cylinder 52 of the device can be provided in the form of a cylindrical carrier with a patterned envelope surface. The pattern comprises raised portions 526 and recessed portions 525 which make up the pattern. The raised portions 526 correspond to portions of material that are to be cut away from the multilayer material 1. The recessed portions 525 correspond to portions of material that are to be kept. The patterned cliché cylinder 52 may be formed as a metal plate 524, which may be made from a magnetic material (e. g. steel) so that it can be magnetically attached to a magnetic carrying cylinder 523, see Fig. 5. Patterned cliché cylinders and the manufacturing of such are known in the art, see for example EP16665912B1, and will not be described further. Figs. 2b and 3b illustrate one example of a patterned cliché cylinder 52. However, it is understood that other embodiments are possible.

Although not illustrated, the device 100, 200, 300, 400 may comprise multiple cliché cylinders for milling. For example, multiple cliché cylinders may be provided in such case the device is to be used for removal of predetermined portions of material in several subsequent milling steps. In such case, the device may be configured such that the multilayer material 1 is registered against the pattern of each cliché cylinder in both the Y_{M}-direction (along the length of the material) and in the X_{M}-direction (across the width of the material). Further, the device may be configured such that registration of the cliché cylinders relative one another in X-driection and Y-direction is performed. In addition, the device may be configured such that a registration of a rotational angle θ of the cliché cylinders is performed.

Consequently, although not illustrated, it is understood that the device 100, 200, 300, 400 may comprise a plurality of milling cutters and/or a plurality of cliché cylinders. For example, a plurality of cooperating milling cutters and cliché cylinders may be arranged for performing several subsequent milling steps.

The at least one milling cutter 51 is configured to, in use, cooperate with the at least one patterned clich6 cylinder 52 to form a nip 6 for removing, at least partially as seen in a thickness direction of a first layer 10 of the multilayer material 1, predetermined portions of material from at least the first layer 10, in accordance with a pattern of the patterned cliché cylinder 52.

As illustrated in Figs. 2-4, the device 100, 200, 300, 400 further comprises a cutting fluid roll-to-roll processing arrangement 150, 250, 350, 450. The cutting fluid roll-to-roll processing arrangement 150, 250, 350, 450 is provided for providing a cutting fluid onto an exposed surface of the multilayer material 1 when in use.

The at least one cutting fluid roll-to-roll processing arrangement may be provided as at least one cutting fluid printing arrangement. For example, the at least one cutting fluid printing arrangement may be an inkjet printing arrangement and/or a Drop-on-Demand-printing arrangement, see for example Figs. 2a-2b. Alternatively, or additionally, the at least one cutting fluid printing arrangement may be a flexographic printing arrangement, see for example Figs. 3a-3b. Alternatively, or additionally, the at least one cutting fluid printing arrangement may be an offset printing arrangement (not illustrated), gravure printing arrangement (not illustrated), and/or screen printing arrangement (not illustrated).

Alternatively, or additionally, the at least one cutting fluid roll-to-roll processing arrangement may be provided as at least one cutting fluid coating arrangement. For example, the at least one cutting fluid coating arrangment may be a slot die coating arrangement (not illustrated) and/or a blade coating arrangement (not illustrated).

The cutting fluid roll-to-roll processing arrangement may be configured to provide the cutting fluid substantially over the entire surface of the top layer of the multialyer material, as seen when in use. Alternatively, the cutting fluid roll-to-roll processing arrangement may be configured to selectively provide the cutting fluid on the exposed surface in accordance with a pattern, which correlates to at least some of said predetermined portions of material that are to be removed from at least the first layer.

As illustrated in Figs. 2a- 2b, the cutting fluid roll-to-roll processing arrangement 150 may comprise at least one controllable nozzle 9. The at least one controllable nozzle 9 may be arranged for providing a cutting fluid onto an exposed surface of the multilayer material 1 when in use.

The at least one nozzle 9 may designed as described above in relation to the method. The at least one nozzle 9 may be configured as described above in relation to the method. For example, the at least one controllable nozzle 9 may be movably arranged, such that it is movable in a cross machine direction. Thus, the at least one controllable nozzle may be movable across a width of the multilayer material. For example, the at least one nozzle may be movably arranged along a holder 90 that is arranged to extend in a cross machine direction, i.e. across the width of the multilayer material as seen when in use, see Fig. 2b. Alternatively, the at least one nozzle may be attached to a holder which is movable in the cross machine direction.

As another alternative, the at least one controllable nozzle 9 may be fixedly arranged. The at least one controllable nozzle 9 may comprise a plurality of openings for providing the cutting fluid. The openings may be distributed along a cross machine direction, i.e. across the width of the muntilayer material 1.

Further, as illustrated in Fig. 2a, the device 100 may comprise a control unit C. The control unit C may be configured as described above in relation to the method.

As illustrated in Figs. 3a-3b, Fig. 4a and Fig. 4b, the cutting fluid roll-to-roll processing arrangement 250, 350, 450 may comprise a rotatably arranged first cutting fluid transfer cylinder 3. The first cutting fluid transfer cylinder 3 can be configured to, in use, pick up a cutting fluid 8' from a cutting fluid supply 80. The first cutting fluid transfer cylinder 3 may designed as described above in relation to the method. The first cutting fluid transfer cylinder 3 may be configured as described above in relation to the method.

Further, as illustrated in Figs. 3a-3b and Fig. 4b, the cutting fluid roll-to-roll processing arrangement 250, 450 may comprise a rotatably arranged intermediate cylinder. The intermediate cylinder can be seen to be arranged between the first cutting fluid transfer cylinder 3 and the multilayer material 1.

Figs. 3a-3b illustrate one example of an intermediate cylinder in form of a second patterned cliché cylinder 5. Fig. 4b illustrate another example of an intermediate cylinder in form of a second cutting fluid transfer cylinder 7.

As illustrated in Figs. 3a-3b, the cutting fluid roll-to-roll processing arrangement 250 may further comprise a rotatably arranged second patterned cliché cylinder 5. The second patterned cliché cylinder 5 may be designed as described above in relation to the method. The second patterned cliché cylinder 5 may be configured as described above in relation to the method.

Thus, the cutting fluid roll-to-roll processing arrangement 250 may be seen to comprise a second patterned cliché cylinder 5 for providing a cutting fluid onto an exposed surface of the multilayer material when in use.

As illustrated in Figs. 3a-3b, the cutting fluid roll-to-roll processing arrangement 250 may further comprise a rotatable cylinder 4. As illustrated in Figs. 3a-3b, the rotatable cylinder 4 can be arranged in cooperation with the second patterned cliché cylinder 5 for feeding the multilayer material 1 therebetween when in use. The rotatable cylinder 4 may be designed as described above in relation to the method. The rotatable cylinder 4 may be configured as described above in relation to the method.

As illustrated in Fig. 4a, the cutting fluid roll-to-roll processing arrangement 350 may be seen to comprise the first cutting fluid transfer cylinder 3. The first cutting fluid transfer cylinder 3 may be designed as described above in relation to the method. The first cutting fluid transfer cylinder 3 may be configured as described above in relation to the method. For example, as illustrated in Fig. 4a, the first cutting fluid transfer cylinder 3 may be configured to, in use, cooperate with said patterned cliché cylinder 52 to form a nip. Thus, the cutting fluid 8" may be provided onto the multilayer material 1 in accordance with the pattern of the clich6 cylinder 52.

As illustrated in Fig. 4b, the cutting fluid roll-to-roll processing arrangement 450 may be seen to further comprise a second cutting fluid transfer cylinder 7. The second cutting fluid transfer cylinder 7 may be designed as described above in relation to the method. The second cutting fluid transfer cylinder 7 may be configured as described above in relation to the method.

Consequently, the cutting fluid roll-to-roll processing arrangement 150, 250, 350, 450 of the device 100, 200, 300, 400 can be seen to comprise at least one of the following: at least one controllable nozzle 9, at least one first cutting fluid transfer cylinder 3, such as for example an anilox roller, at least one cliché cylinder 5, 52, at least one rotatable cylinder 4, such as for example an impression roller, and/or at least one second cutting fluid transfer cylinder 7.

Although not illustrated, it is understood that various combinations of cutting fluid roll-to-roll processing arrangements may be provided. For example, various combinations of the cutting fluid roll-to-roll processing arrangements 150, 250, 350, 450 as illustrated and described in relation to Figs. 2-4 may be provided. For example, the device may comprise a plurality of cutting fluid roll-to-roll processing arrangements. The plurality of cutting fluid roll-to-roll processing arrangements may be designed essentially the same, or differently. The plurality of cutting fluid roll-to-roll processing arrangements may be configured essentially the same, or differently. A plurality of cutting fluid roll-to-roll processing arrangements may for example be advantageous if the device is to be used for several subsequent milling steps.

## Claims

1. A method of producing a product comprising a substrate with at least one patterned layer from a multilayer material (1), the method comprising:
providing the multilayer material (1) comprising at least a first layer (10) and a second layer (20),
providing a cutting fluid (8) on an exposed surface (15) of the multilayer material (1), and
passing the multilayer material (1) through at least one nip (6), wherein said nip (6) is provided by a milling cutter (51) cooperating with a patterned cliché cylinder (52), to at least partially, as seen in a thickness direction of the first layer (10), remove at least some predetermined portions of material from at least the first layer (10) of the multilayer material (1),
**characterized by**
said cutting fluid (8) being provided on the exposed surface (15) by roll-to-roll processing the cutting fluid (8) on the exposed surface (15).

2. The method according to claim 1, wherein the roll-to-roll processing comprises printing the cutting fluid (8) on the exposed surface (15).

3. The method according to any one of the preceding claims, wherein the roll-to-roll processing comprises inkjet printing, Drop-on-Demand-printing, flexographic printing, offset printing, gravure printing, screen printing, slot die coating and/or blade coating the cutting fluid (8) on the exposed surface (15).

4. The method according to any one of the preceding claims, comprising selectively providing said cutting fluid (8) on the exposed surface (15) in accordance with a pattern, which correlates to at least some of said predetermined portions of material that are to be removed from at least the first layer (10).

5. The method according to any one of the preceding claims, wherein the cutting fluid (8) is provided on the exposed surface by means of at least one controllable nozzle (9).

6. The method according to claim 5, further comprising controlling, by means of a control unit (C), the at least one controllable nozzle (9) such that the cutting fluid (8) is only provided on a plurality of edge portions of said predetermined portions of material that are to be removed.

7. The method according to any one of the preceding claims, wherein a first cutting fluid transfer cylinder (3) is rotatably arranged to pick up the cutting fluid (8') from a cutting fluid supply (80).

8. A device (100, 200, 300, 400) for producing a product comprising a substrate with at least one patterned layer from a multilayer material (1), the device (100, 200, 300, 400) comprising:
at least one milling cutter (51) and at least one patterned clich6 cylinder (52),
wherein the at least one milling cutter (51) is configured to, in use, cooperate with the at least one patterned cliché cylinder (52) to form a nip (6), for removing, at least partially as seen in a thickness direction of a first layer of the multilayer material, predetermined portions of material from at least the first layer, in accordance with a pattern of the patterned cliché cylinder (52),
**characterized in that**
the device (100, 200, 300, 400) further comprises at least one cutting fluid roll-to-roll processing arrangement (150, 250, 350, 450) for providing a cutting fluid on an exposed surface of the multilayer material.

9. The device according to claim 8, wherein the at least one cutting fluid roll-to-roll processing arrangement is a cutting fluid printing arrangement.

10. The device according to claim 8 or 9, wherein the at least one cutting fluid roll-to-roll processing arrangement is an inkjet printing arrangement, Drop-on-Demand-printing arrangement, flexographic printing arrangement, offset printing arrangement, gravure printing arrangement, screen printing arrangement, slot die coating arrangement and/or blade coating arrangement.

11. The device according to any one of claims 8-10, wherein the cutting fluid roll-to-roll processing arrangement (150, 250, 350, 450) is configured to selectively provide the cutting fluid on the exposed surface in accordance with a pattern, which correlates to at least some of said predetermined portions of material that are to be removed from at least the first layer.

12. The device (100) according to any one of claims 8-11, wherein the cutting fluid roll-to-roll processing arrangement (150) comprises at least one controllable nozzle (9) for providing a cutting fluid onto an exposed surface of the multilayer material (1).

13. The device according to any one of claims 8-12, wherein the cutting fluid roll-to-roll processing arrangement (250, 350, 450) comprises a rotatably arranged first cutting fluid transfer cylinder (3) configured to, in use, pick up a cutting fluid (8') from a cutting fluid supply (80).

14. The device according to any one of claims 8-13, wherein the cutting fluid roll-to-roll processing arrangement (250, 450) comprises a rotatably arranged intermediate cylinder.

15. The device according to claim 14, wherein the intermediate cylinder is a second patterned cliché cylinder (5) or a second cutting fluid transfer cylinder (7).
